# EUROPEAN PATENT APPLICATION

(11) **EP 3 603 875 A1**
(43) Date of publication of application: **05.02.2020**
(21) Application number: 18776776.9
(22) Date of filing: 08.03.2018
(51) Int. Cl.: B23K 35/14, B22F 1/00, B22F 1/02, B23K 35/26, B23K 35/40

(54) **JOINING MOLDED ARTICLE AND METHOD FOR MANUFACTURING SAME**

(30) Priority: 31.03.2017 JP 2017071964
(71) Applicant: Mitsubishi Materials Corporation, Chiyoda-ku, Tokyo 100-8117 (JP)
(72) Inventor: HIGAMI, Akihiro, Naka-shi Ibaraki 311-0102 (JP); MURAOKA, Hiroki, Naka-shi Ibaraki 311-0102 (JP); IWATA, Kotaro, Naka-shi Ibaraki 311-0102 (JP); YAMAGUCHI, Tomohiko, Naka-shi Ibaraki 311-0102 (JP)
(74) Representative: Gille Hrabal
(86) International application number: PCT/JP2018/008884
(87) International publication number: WO 2018/180326

(57) **Abstract**

The present invention is a molded body (1) for joining composed of a compressed aggregate of Cu-core Sn-shell powders (2), the molded body for joining has an activating agent-containing substance (4) for eliminating an oxide of the powder surface existing on the surface portion of the molded body for joining and open holes therewithin; contains Cu in a ratio of 55 to 95% by mass and Sn in a ratio of 45 to 5% by mass; and has a thickness of 20 to 400 µm.

## Description

### TECHNICAL FIELD

The present invention relates to a joining molded article (a molded body for joining) and a method for manufacturing the same, which are suitably used in allowing the molded body for joining to be interposed between electronic components such as semiconductor chip elements, or LED chip elements, etc. which are members to be joined and a substrate to mount such electronic components which are members to be joined onto the substrate. It is to be noted that the present International Application claims the priority based on the Japanese Patent Application No. 71964, filed on March 31, 2017 (JP2017-71964), the entire contents of the JP2017-71964 being incorporated in the present International Application.

### BACKGROUND ART

In recent years, attention has been drawn to wide-gap semiconductors like Si, which operate even at a high temperature above 200°C. As a method of joining semiconductor chip elements which operate at a high temperature, attention has been drawn to a joining method called the Transient Liquid Phase Sintering Method (TLP method) of allowing bonding materials containing Cu and Sn to be interposed between semiconductor chip elements and the substrate to apply heating thereto at a temperature higher than the melting point of Sn to allow the bonding material to be Inter-Metallic Compound (IMC) having a composition of Cu₆Sn₅ or Cu₃Sn. A Cu-core Sn-shell powder preform for high-temperature applications based on such bonding method is disclosed (see e.g., Nonpatent Literature 1).

For Cu-core Sn-shell powder preform of the Nonpatent Literature 1, Cu particles having a particle size of 30 µm are dropped into an electroless Sn plating solution so that they are coated with Sn layer having a thickness of about 2 to 3 µm thereafter to press these particles such that there result preform, i.e., molded bodies for the next applications. Respective Cu particles in the molded body are coated with Sn layers to form Cu-core Sn-shell powder structure. When the molded body is heated up to 232°C, the Sn layer of the outer shell is molten and is then integrated with molten Sn of neighboring particles so that air gaps which was present at gaps between these particles are discharged to the bonding layer and are thus densified. By this method, Cu particles will be uniformly distributed at the bonding surface thereof. When the reflow time is prolonged, Cu₆Sn₅ compound and Cu₃Sn compound are formed by interdiffusion between Cu core and Sn shell. Finally, Sn of the outer shell will be completely consumed so that it results in intermetallic compound (IMC). Because Cu particles are surrounded by Cu-Sn inter-metallic compound (Cu₆Sn₅ or Cu₃Sn), and melting points of Cu₆Sn₅ and Cu₃Sn are respectively 415°C and 676°C, it is possible to tolerate higher temperatures at least up to 415°C.

### PRIOR ART DOCUMENT

### PATENT DOCUMENT

Nonpatent Literature 1:Tianqi Hu et al., "Cu@SnCore-Shell Structure Powder Preform for High-Temperature Applications Based on Transient Liquid Phase Bonding", IEEE Transactions on Power Electronics, February 2016

### SUMMARY OF THE INVENTION

### PROBLEM TO BE SOLVED BY THE INVENTION

However, with Cu-core Sn-shell structure powder preform described in the nonpatent literature 1, in the case where a native oxide film is formed on the surface of the Cu-core Sn-shell structure powder before molding, even if this preform, i.e., the molded body is disposed between the semiconductor chip element which is a member to be bonded and the substrate to implement reflow thereto, Sn of the outer shell was difficult to get wet with the Cu particle surface, and it was thus difficult to bond the semiconductor chip element onto the substrate at a high strength.

An object of the present invention is to provide a molded body for joining and a method of manufacturing the same, which can solve the above-mentioned problems to realize joining having an initial joining strength and sufficient to maintain a higher joining strength also after the thermal cycle.

### MEANS FOR SOLVING PROBLEM

A first aspect of the present invention is a molded body for joining composed of a compressed aggregate of Cu-core Sn-shell powders, characterized in that an activating agent-containing substance for eliminating oxides on the powder surface exists at surface portions of the molded body for joining and in open holes therewithin; that the molded body for joining contains Cu in a ratio of 55 to 95% by mass and Sn in a ratio of 45 to 5% by mass respectively; and that the molded body for joining has a thickness of 20 to 400 µm. In this specification, "open hole" refers to a pore communicating with the exterior surface of the molded body for joining (open pore) among pores existing within the molded body for joining, and "closed hole" refers to a pore which does not communicate with the exterior surface of the molded body for joining (closed pore).

A second aspect of the present invention is a method of manufacturing a molded body for joining, characterized by including: a step of allowing Cu-core Sn-shell powders having an average particle size of 0.5 to 50 µm to undergo the press forming or the roll rolling forming at a pressure of 10 to 1000 MPa to obtain a molded body precursor in the form of pellet or sheet having a thickness of 20 to 400 µm, a step of storing, into a container, an activating agent-containing substance in the form of liquid for eliminating an oxide on the surfaces of the powders under the atmosphere of an inert gas to immerse the molded body precursor into the activating agent-containing substance; a step of decompressing, together with the container, the immersed molded body precursor under the atmosphere of an inert gas to remove, from open holes within the molded body precursor, gas existing in the open holes; a step of restoring a pressure of the molded body precursor in which the gas has been removed from the open holes so as to have a normal pressure to fill the activating agent-containing substance into the open holes; and a step of eliminating an excess activating agent-containing substance attached on the surface of the molded body precursor in which the activating agent-containing substance has been filled in the open holes to obtain a molded body for joining, and in that the Cu-core Sn-shell powder contains Cu in a 55 to 35% by mass and Sn in a 45 to 5% by mass respectively.

### EFFECT OF THE INVENTION

In the molded body for joining according to the first aspect of the present invention, on a surface portion of the molded body for joining comprised of compressed aggregate of the Cu-core Sn-shell powders and open holes therewithin, there exists an activating agent-containing substance for eliminating oxides on the powder surfaces thereof. By such structural characteristic, at the time of preserving the molded body for joining, it is possible to prevent oxidation of Sn on the surface portion of the molded body for joining and the outer shell facing the open holes. Moreover, even if any native oxide film is formed on the surface portion of the molded body for joining and the surface of the outer shell Sn, when such molded body for joining is disposed on a bonding surface of the joined member like the electronic components and the substrate to apply joining by heating (hereinafter referred to as joining heating) thereto, the activating agent in the activating agent-containing substance can eliminate the oxide of the surface portion and the outer shell Sn. Thus, Sn will be molten in a short time and is allowed to get wet with the Cu-core particle surface so that liquid phase sintering is rapidly developed, and Sn will be joined to the outer shell Sn of the adjacent Cu-core Sn-shell powder so that there can result an integrated bonding layer. If the joining heating is continued, inter-diffusion between Cu of the core and Sn of the shell takes place so that there are formed densified bonded layer having high temperature resistance where the Cu core particles are surrounded by Cu₆Sn₅ compound and Cu₃Sn compound, thus making it possible to realize a joining having a higher initial joining strength and sufficient to maintain a higher joining strength also after the thermal cycle test. In addition, as the result of the fact that Cu remains within the molded body for joining, when a bonding layer is formed by using this molded body for joining, the bonding layer is permitted to have a higher thermal conductivity and a higher electric conductivity.

In the method of manufacturing a molded body for joining according to the second aspect of the present invention, press forming or roll rolling forming is implemented so that there can be provided a molded body in which there exists less air gap therewithin from the stage before joining heating. As a result, it becomes easier to densify the bonding layer at the time of joining heating. Moreover, because after not only Cu-core Sn-shell powders are pressed to manufacture a molded body as in the Nonpatent literature 1, but also Cu-core Sn-shell powders are subjected to press forming or roll rolling forming to manufacture a molded body precursor, an activating agent-containing substance is adhered onto the inner walls of open holes within the molded body precursor and the surface portion of the molded body precursor, although gaps, i.e., both closed holes and open holes remain to be formed between Cu-core Sn-shell powders in the method of the Nonpatent literature 1, the surface portion of the molded body for joining and the inner walls of the open holes are covered with the activating agent-containing substance by this method. As a result, it is possible to manufacture a molded body for joining having many contacts between powders and including activating agent-containing substance existing at the surface portion and the open holes thereof. Particularly, there is no contact with the atmosphere at the surface portion and the open holes to prevent oxidation when preserving the molded body for joining, and to permit the activating agent to eliminate oxides on the surface portion and the open hole surfaces at the time of joining heating so that the liquid phase sintering will be rapidly developed.

### BRIEF DESCRIPTION OF DRAWINGS

FIG. 1 is a diagram schematically illustrating steps of manufacturing, by the press forming, a molded body for joining according to a first embodiment of the present invention.
FIG. 2 is a diagram schematically illustrating steps of manufacturing, by the roll rolling forming, a molded body for joining according to a second embodiment of the present invention.

### BEST MODE(S) FOR CARRYING OUT THE INVENTION

The modes for carrying out the present invention will now be described on the basis of the attached drawings.

### <First embodiment>

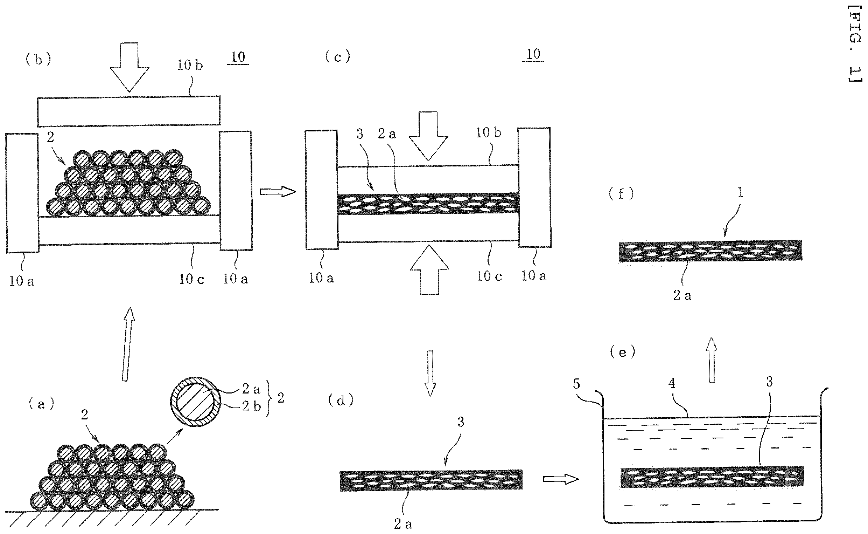

As illustrated in FIG. 1, a molded body 1 for joining according to a first embodiment of the present invention is manufactured in the form of pellet or sheet having a thickness of 20 to 400 µm by implementing press forming to the Cu-core Sn-shell powders 2.

### [Cu-core Sn-shell powder]

The Cu-core Sn-shell powder 2 serving as a raw material of a molded body for joining is composed, as illustrated in the enlarged diagram of FIG. 1(a), a core 2a consisting of Cu, and a shell 2b consisting of Sn, which covers the core 2a. The average particle size of the Cu-core Sn-shell powder 2 is 0.5 to 50 µm, preferably 1.0 to 20 µm. When the average particle size is less than 0.5 µm which is the lower limit, it is known that not only it is difficult to manufacture molded body precursors having a uniform density in carrying out the press forming or the roll rolling forming which will be described later, but also diffusion of Cu will be developed in several hours of Cu on the interface between Cu and Sn of the double layered particles under a temperature to handle ordinary materials such as 25°C, etc. Therefore, substantially the total amount of the outer shell Sn would result in Cu₆Sn₅ in the middle of temperature elevation before the Sn liquid phase is produced at the time of joining heating, leading to the fact that the joining performance will be inconveniently deteriorated. On the other hand, when the average particle size is above 50 µm of the upper limit, Sn will be molten at the time of joining heating so that it becomes easier to be integrated, but Cu and Sn are subjected to interdiffusion so that much time is required in order to form inter-metallic compound. As a result, there is an inconvenience that short time joining which is one of effects of the present invention fails to be realized. Further, in the case of obtaining a molded body precursor which is thinner than the particle size of Cu disposed at the center of the powder of the double layered structure, it is necessary to deform not only Sn of the shell but also Cu, but there is an inconvenience such that because Cu is harder than Sn so that it is not easily deformed, when the average particle size is above 50 µm of the upper limit, Cu will be exposed to the uppermost surface thereof, and Cu is thus oxidized so that the wettability will be deteriorated, and because the existing ratio of Sn of the surface portion is reduced, Sn of the liquid phase pertaining to the joining is difficult to appear on the joining surface, thus deteriorating the joining property. It is to be noted that average particle sizes (volumetric base) of powders are values measured by the laser diffraction scattering method (made by Horiba Seisakusho, LA960).

Moreover, the Cu-core Sn-shell powder 2 contains, when the Cu-core Sn-shell powder is assumed as 100% by mass, Cu in a ratio of 55 to 95% by mass and Sn in a ratio of 45 to 5% by mass respectively. Preferred contents are respectively 60 to 85% by mass for Cu and 40 to 15% by mass for Sn. When the content of Cu is above 95% by mass and the content of Sn is less than 5% by mass, there is an inconvenience that sinterability at the time of joining heating is low, and the bonding layer is not integrated so that the joining strength becomes lower and the thermal resistance becomes high. Further, when the content of Cu is less than 55% by mass and the content of Sn is above 45% by mass, there is an inconvenience such that high temperature heat resistance of the final composition of the bonding layer is low so that any expected performance cannot be provided.

As a method of manufacturing the Cu-core Sn-shell powder 2, there are mentioned a method of manufacturing both the core and the shell by the wet method, and a method of manufacturing, by the wet method, only the shell by using Cu fine powder as the core. In the former manufacturing method, reducing agent is first added into an aqueous solution in which Cu ions and Sn ions coexist to allow Cu which has a higher oxidation-reduction potential to be subjected to reductive deposition, and to subsequently allow Sn having a lower oxidation-reduction potential to be subjected to reductive deposition so as to cover this Cu to thereby manufacture powder precursor of the Cu-core Sn-shell structure. For the reducing agent, there may be employed a manipulation to stepwise add weak reducing agent which reduces only Cu and strong reducing agent which also reduces Sn so that reductive deposition reaction for Cu and reductive deposition reaction for Sn are separate. Further, in the latter manufacturing method, Cu fine powders may be prepared in advance to allow them to be highly dispersed in an aqueous solution containing Sn ions to add reducing agent thereinto to allow Sn to be subjected to reductive deposition onto the dispersed Cu fine powder surface. Further, for the purpose of preventing aggregation of the powder precursor of the synthesized Cu-core Sn-shell structure, dispersant such as hydroxypropyl methylcellulose or polyvinyl pyrrolidone, etc. may be added into the aqueous solution at the time of preparing the aqueous solution. By washing powder precursors of the synthesized Cu-core Sn-shell structure thereafter to collect and dry them, fine powders of the Cu-core Sn-shell structure are provided.

### [Manufacturing of the molded body precursor]

As illustrated in FIG. 1(b) and FIG. 1(c), Cu-core Sn-shell powders 2 are subjected to press forming by means of uniaxial press machine 10 under the atmosphere of an inert gas such as nitrogen, or argon to manufacture molded body precursor 3. The uniaxial press machine 10 includes a die 10a serving as a metal mold, an upper punch 10b, and a lower punch 10c. In order to manufacture a molded body precursor 3 by means of this uniaxial press machine 10, Cu-core Sn-shell powder 2 is weighed by a predetermined amount thereof in the state where the lower punch 10c is first combined with the die 10a to insert it from an upper punch insertion hole of the die 10a onto the lower punch 10c (FIG. 1(b)). Although not illustrated, the Cu-core Sn-shell powders 2 are subjected to tapping from the above by means of jig so that they are allowed to have a uniform thickness. Next, the upper punch 10b is inserted into the die 10a, and is then lowered (FIG. 1(c)). The Cu-core Sn-shell powders 2 are deformed by pressure applying force of the upper punch 10b. Thus, there take place intertwining and/or adhesion between powders so that there results an independent molded body precursor 3. In this way, the Cu-core Sn-shell powders 2 are subjected to uniaxial pressing by means of the uniaxial press machine 10 to implement forming thereto so as to have a predetermined thickness of 20 to 400 µm. The molding or forming pressures vary in dependency upon particle size and/or composition of the Cu-core Sn-shell powders 2. For this reason, it is impossible to individually limit them in order that there result pressures corresponding to particle sizes, compositions and/or shapes of respective fine powders, but press forming is carried out within the range between 10 and 1000 MPa. At this time, the cross section of the molded body precursor 3 is observed to determine an amount of powders to be added so that the area of air gaps consisting of components except for metallic components of Cu and Sn becomes equal to 5% to 0.1%, and to make pressure adjustment such that it has the predetermined thickness. Although not illustrated, the air gap portion is composed of closed holes and open holes. Cu of the core in the molded body precursor which is a compressed aggregate is indicated at reference symbol 2a (FIG 1(c)).

After the uniaxial press forming, the upper punch 10b is released from the mold to take out the molded body precursor 3 therefrom as illustrated in FIG. 1(d) . A molded body precursor in the form of pellet or sheet is obtained in dependency upon the shape of the metal mold. The shape and the size of the molded body precursor are determined in accordance with the shape and the size of the joining surface of electronic components which are members to be joined. The molded body precursor obtained by the uniaxial press forming is composed of a compressed aggregate of Cu-core Sn-shell powders. Cu and Sn are contained in the molded body precursor in a ratio of 55 to 95% by mass and in a ratio of 45 to 5% by mass respectively.

### [Immersion into the activating agent-containing substance of the molded body precursor]

As illustrated in FIG. 1(e), activating agent containing substance 4 in the liquid form for eliminating oxides on the powder surfaces within the molded body precursor are stored into a container 5. It is to be noted that the viscosity of the activating agent-containing substance is adjusted to be 10⁻² to 10 Pa·s. The molded body precursor 3 thus obtained is immersed into the stored activating agent-containing substance 4 under the atmosphere of an inert gas such as nitrogen or argon. The activating agent-containing substance 4 is flux containing activating-agent component, or solvent containing activating-agent component. As such activating agent, hydrogen halide acid amine salt is preferably adopted, and there are specifically mentioned hydrochloride or hydrobromide of amine such as triethanolamine, diphenyl guanidine, ethanolamine, butylamine, aminopropanol, polyoxyyethylene oleylamine, polyoxyethylene laurelamine, polyoxyethylene stearilamine, diethylamine, triethylamine, methoxypropylamine, dimethylaminopropylamine, dibutylaminopropylamine, ethyl hexylamine, ethoxypropylamine, ethylhexyl oxypropropylamine, bispropylamine, isopropylamine, diisopropylamine, piperidine, 2, 6 - dimethylpiperidine, aniline, methylamine, ethylamine, butylamine, 3 - amino - 1 - propene, isopropylamine, dimethyl hexylamine, cyclohexylamine, etc. Among these materials, cyclohexylamine hydrobromide may be preferably adopted.

As the solvent, there are mentioned organic solvents having a boiling point of 180°C or more such as diethylene glycol monohexyl ether, diethylene glycol monobutyl ether, diethylene glycol monobutyl ether acetate, tetraethylene glycol, 2 - ethyl - 1, 3 - hexanediol, and α - terpineol, etc. Among these substances, α - terpineol may be preferably adopted. For the activating agent containing substance consisting of solvent containing activating agent component, there may be mentioned, e.g., a substance obtained by containing activating agent component included into a solvent in which sebacic acid is dissolved into α - terpineol at a concentration of 5% by mass.

In the flux, in addition to the activating agent, the above-mentioned solvents, rosin and thixo agent may be included. For the activating agent containing substance consisting of flux containing activating agent component, there may be mentioned, e.g., general purpose flux for lead free solder (92MS, made by Arakawa Kagaku). The content ratio of the activating agent included in the flux or the solvent is 0.01 to 2% by mass, preferably 0.5 to 1% by mass in the flux or the solvent.

### [Filling of activating agent-containing substance into open holes within the molded body precursor]

Molded body precursor 3 which has been immersed in the activating agent-containing substance is decompressed together with container 5 under the atmosphere of an inert gas such as nitrogen, or argon. While decompression (the degree of vacuum) is varied in accordance with viscosity of the activating agent-containing substance, or vapor pressure of solvent used in the activating agent-containing substance is varied, setting is made to the degree of vacuum which is twice or more than a value that the vapor pressure at 25°C is the highest among solvents used for the activating agent-containing substance and to the range of 0.1 to 5 kPa. to hold such setting for a time period until any gas evolution is not recognized from the molded body precursor under such decompression for 30 to 600 sec. Thus, gas existing in open holes within the molded body precursor 3 is caused to be swollen to perform degassing from these open holes. When the degree of vacuum and decompression time are less than the lower limit of the above-mentioned range, the degassing described above is not sufficiently performed. When the degree of vacuum and decompression time are above the upper limit of the above-mentioned range, there is an inconvenience that a solvent of which vapor pressure is high is volatized so that the composition of activating agent-containing substance to be filled into the open holes remarkably deviate, so expected functions of prevention of oxidation and surface oxide film removal are not exhibited. After decompression has been performed, the molded body precursor 3 immersed in the activating agent-containing substance is caused to undergo, together with the container 5, pressure restoring into a normal pressure for 300 to 1200 sec. under the atmosphere of an inert gas. Thus, activating agent-containing substance 4 will be filled into the open holes within the molded body precursor 3. By performing pressure restoring to fill activating agent-containing substance into the open holes thereafter to take out the molded body precursor from the container to pull out and eliminate, under the inert gas atmosphere, activating agent-containing substance attached on the surface of the molded body precursor and thus to perform drying as occasion demands, molded body 1 for joining illustrated in FIG. 1(f) is provided.

### <Second embodiment>

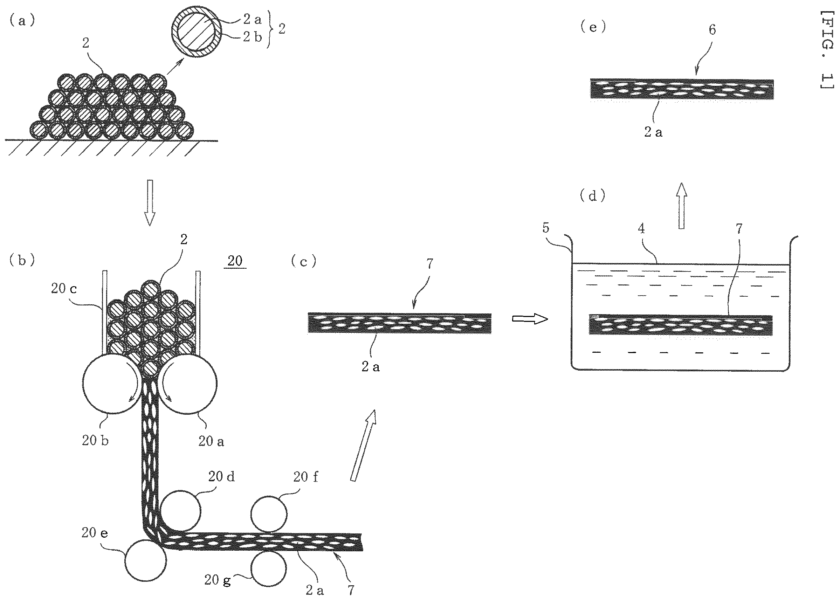

As illustrated in FIG. 2, molded body 6 for joining according to the second embodiment of the present invention is manufactured in the form of sheet or in the form of pellet having a thickness of 20 to 400 µm by allowing the Cu-core Sn-shell powder 2 (FIG. 2(a)) to undergo roll rolling forming which is the same as the first embodiment.

### [Manufacturing of molded body precursor]

As illustrated in FIG. 2(b), by allowing the Cu-core Sn-shell powders 2 to undergo powder roll rolling forming by means of a powder rolling mill 20 under the atmosphere of an inert gas such as nitrogen or argon, a molded body precursor 7 is manufactured. The powder rolling mill 20 includes a pair of columnar rolls 20a and 20b, and a hopper 20c provided in a manner in contact with the upper surfaces of these rolls. The roll 20a and the roll 20b are configured to rotate in directions opposite to each other to perform, in a lower direction, rolling of the Cu-core Sn-shell powders 2 inserted into the hopper 20c so that the rolled body is guided in a horizontal direction by means of guide rollers 20d to 20g. A pressure at the time of roll rolling results in a linear pressure, and it is difficult to perform confirmation and management of a pressure applied to the Cu-core Sn-shell powders actually rolling-molded. For this reason, although it is impossible to limit pressure, there may be employed a scheme to adjust a gap between rolls such that the molded body precursor 7 takes a predetermined thickness of 20 to 400 µm in a manner similar to the uniaxial press forming of the first embodiment, and to adjust, upon observing the cross section of the molded body precursor 7, an amount of the Cu-core Sn-shell powders 2 by the hopper 20c so that the air gap portion becomes equal to 5% to 0.1%. Although not illustrated, the air gap portion is composed of closed holes and open holes. Cu of the core in the molded precursor which is a compressed aggregate is indicated at reference numeral 2a (FIG. 2(b)).

After the roll rolling forming, by cutting the rolled molded body precursor so as to have a predetermined size, a molded body precursor in the form of sheet or in the form of pellet is provided as illustrated in Fig. 2(c). The shape and the size of the molded body precursor 7 are determined in accordance with the shape and the size of the joining surface of electronic components which are members to be joined. The molded body precursor obtained by the roll rolling forming is composed of a compressed aggregate of Cu-core Sn-shell powders. Cu and Sn are respectively contained in the molded body precursor in a ratio of 55 to 95% by mass and in a ratio of 45 to 5% by mass.

### [Immersion into the activating agent-containing substance in the molded body precursor and filling of the activating agent-containing substance into open holes within the molded body precursor]

Since the activating agent-containing substance of the second embodiment is the same as the activating agent-containing substance of the first embodiment, and as illustrated in Fig 2(d) and 2(e), a method of immersing molded body precursor after the roll rolling forming into the activating agent-containing substance and a method of filling the activating agent-containing substance into open holes within the molded body precursor are similar to those of the first embodiment, repetitive explanation will be omitted. In this way, molded body 6 for joining of the second embodiment is provided. In Fig 2(d) and 2(e), reference numerals of respective elements are the same as reference numerals marked to the elements illustrated in FIG 1(e) and Fig. 1(f).

### [Joining method using molded body for joining]

An example of joining a silicon chip element to a substrate of a copper plate by using molded bodies for joining manufactured in accordance with the above-mentioned methods of the first and second embodiments to mount the silicon chip element onto the substrate will now be descried. First, the molded body for joining is disposed on the copper plate to mount, on the molded body for joining, a 2.5 mm square silicon chip element of which back surface has been subjected to Au sputtering. Next, heating holding treatment is performed for 1 to 15 min. under the condition of the maximum temperature 250 to 350°C while applying load of 0.1 to 100 MPa under nitrogen gas atmosphere by using a bonding furnace, e.g. SRS-1C made by MALCOM company. As the result of the fact that the activating agent in the molded body for joining eliminates oxide of the outer shell Sn layer of the powder by the joining heating described above, Sn is molten in a short time so that inter-metallic compound (IMC) is formed so as to surround Cu of the core by the interdiffusion between Cu and Sn. Thus, the silicon chip element and the copper plate are joined at a high joining strength.

Regarding this joining heating condition, the heating temperature and the heating time are determined from the above-mentioned range in dependency upon the average particle size of the Cu-core Sn-shell powders in the molded body for joining. As the average particle size of the Cu-core Sn-shell powders become smaller, a lower heating temperature and a shorter heating time are determined within the range, and according as the average particle size of the Cu-core Sn-shell powders become larger, a higher heating temperature and a longer heating time are determined within the range. When the heating temperature is less than 250°C or the heating time is less than one min., even if the average particle size is 0.5 µm, Sn is not easily molten so that no inter-metallic compound of Cu-Sn is formed, so the joining strength is not allowed to be high. Further, when the heating temperature is above 350°C or the heating time is above 15 min., there is an inconvenience that thermal damage may be applied to silicon chip element which is a member to be joined.

### EXAMPLES

Examples according to the present invention will now be described in more detail in conjunction with comparative examples.

### <Example 1>

There was prepared a Cu-core Sn-shell powder in which the average particle size is 0.5 µm, and the Cu ratio is 75% by mass and Sn ratio is 25% by mass. In this example, the composition ratio of Cu and Sn of the Cu-core Sn-shell powder was measured by the ICP emission spectroscopy (made by the Thermo Fisher Scientific company, iCAP-6500 Duo). Moreover, the fact that the crystal structure of the core-shell structure mainly consists of Cu and Sn was confirmed by the powder X-ray diffraction method (made by the PANalytical company, Multipurpose X-ray diffraction device Empyrean). The Cu-core Sn-shell powders were subjected to uniaxial-pressing for 300 sec. at 500 MPa by using the metal mold to obtain a 3 mm square molded body precursor in the form of pellet having a thickness of 100 µm.

On the other hand, an activating agent-containing substance in the form of liquid in which general purpose flux has been diluted by α-terpineol of the organic solvent was obtained so that the content of general purpose flux (made by Arakawa Kagaku 92MS) becomes equal to 10% by mass. 50 ml of this activating agent-containing substance is inserted into a container of 100 ml glass beaker. The molded body precursor was immersed into the activating agent-containing substance stored in this container. The container including the activating agent-containing substances, in which the molded body precursor has been immersed was accommodated into a vacuum dryer to decompress the inside of the vacuum dryer casing by means of an attached oil rotation vacuum pump at a room temperature to swell gas existing in the open holes communicating with the exterior surface of the molded body precursor to perform degassing from the molded body precursor. The degree of vacuum was set to 1 kPa to hold this for 300 sec. thereafter to introduce nitrogen over 600 sec. to gradually restore into a normal pressure to fill the activating agent-containing substance in the open holes communicating with the exterior surface of the molded body precursor. The molded body precursor in which the activating agent-containing substance has been filled was taken out from the container to pull out excess activating agent-containing substance adhered on the surface thereof to obtain a 3 mm square pellet-shaped molded body for joining having a thickness of 100 µm.

### <Examples 2 to 5 and Comparative examples 1, 2>

In the examples 2 to 5 and the comparative examples 1, 2, as shown in Table 1, with respect to average particle sizes of the Cu-core Sn-shell powders for manufacturing molded bodies for joining, molded bodies for joining were obtained in a manner similar to the example 1 by using Cu-core Sn-shell powders having average particle sizes different from those of the example 1.

### <Examples 6 to 9 and Comparative examples 3, 4>

In the examples 6 to 9 and the comparative examples 3, 4, as shown in Table 1, with respect to the composition of Cu and Sn of the Cu-core Sn-shell powders for manufacturing molded bodies for joining, molded bodies for joining were obtained in a manner similar to the example 1 by using Cu-core Sn-shell powders having compositions different from the example 1.

### <Examples 10 to 13 and Comparative examples 5, 6>

In the examples 10 to 13 and the comparative examples 5, 6, as shown in Table 1, with respect to forming loads in performing the uniaxial press forming when manufacturing molded body for joining, molded bodies for joining were obtained in a manner similar to the example 1 by forming loads different from the example 1. The time during which load has been applied was 300 sec. which is the same as the example 1.

**Table 1**

| | Cu-core Sn-shell powder | | | Molded body precursor | | Forming condition | | | Joining evaluation | |
|---|---|---|---|---|---|---|---|---|---|---|
| | Average particle size (µm) | Composition | | Cu-Sn component (% by mass) | Activating agent component (% by mass) | Forming method (-) | Forming load (MPa) | Molded body thickness (µm) | Initial joining strength (MPa) | Thermal cycle (-) |
| | | Cu (% by mass) | Sn (% by mass) | | | | | | | |
| Example 1 | 0.5 | 75 | 25 | 99.0 | 1.0 | Uniaxial press | 500 | 100 | 37 | 0.79 |
| Example 2 | 1.0 | 75 | 25 | 99.0 | 1.0 | Uniaxial press | 500 | 100 | 49 | 0.90 |
| Example 3 | 5.0 | 75 | 25 | 99.0 | 1.0 | Uniaxial press | 500 | 100 | 54 | 0.98 |
| Example 4 | 20 | 75 | 25 | 99.0 | 1.0 | Uniaxial press | 500 | 100 | 47 | 0.87 |
| Example 5 | 50 | 75 | 25 | 99.0 | 1.0 | Uniaxial press | 500 | 100 | 39 | 0.85 |
| Comparative Example 1 | 0.3 | 75 | 25 | 99.0 | 1.0 | Uniaxial press | 500 | 100 | 19 | 0.48 |
| Comparative example 2 | 60 | 75 | 25 | 99.0 | 1.0 | Uniaxial press | 500 | 100 | 23 | 0.35 |
| Example 6 | 5.0 | 55 | 45 | 99.0 | 1.0 | Uniaxial press | 500 | 100 | 56 | 0.68 |
| Example 7 | 5.0 | 60 | 40 | 99.0 | 1.0 | Uniaxial press | 500 | 100 | 54 | 0.72 |
| Example 8 | 5.0 | 85 | 15 | 99.0 | 1.0 | Uniaxial press | 500 | 100 | 47 | 0.90 |
| Example 9 | 5.0 | 95 | 5 | 99.0 | 1.0 | Uniaxial press | 500 | 100 | 43 | 0.92 |
| Comparative example 3 | 5.0 | 50 | 50 | 99.0 | 1.0 | Uniaxial press | 500 | 100 | 49 | 0.15 |
| Comparative example 4 | 5.0 | 97 | 3 | 99.0 | 1.0 | Uniaxial press | 500 | 100 | Joining impossible | - |
| Example 10 | 5.0 | 75 | 25 | 99.0 | 1.0 | Uniaxial press | 10 | 100 | 40 | 0.79 |
| Example 11 | 5.0 | 75 | 25 | 99.0 | 1.0 | Uniaxial press | 50 | 100 | 43 | 0.81 |
| Example 12 | 5.0 | 75 | 25 | 99.0 | 1.0 | Uniaxial press | 100 | 100 | 51 | 0.93 |
| Example 13 | 5.0 | 75 | 25 | 99.0 | 1.0 | Uniaxial press | 1000 | 100 | 49 | 0.92 |
| Comparative Example 5 | 5.0 | 75 | 25 | 99.0 | 1.0 | Uniaxial press | 5 | 100 | 20 | 0.19 |
| Comparative Example 6 | 5.0 | 75 | 25 | 99.0 | 1.0 | Uniaxial press | 2000 | 100 | 28 | 0.33 |

### <Examples 14 to 17 and comparative examples 7, 8>

In the examples 14 to 17 and the comparative examples 7, 8, as shown in Table 2, by varying an amount of Cu-cure Sn-shell powders to be inserted into the metal mold, thicknesses of obtained molded bodies for joining were made to be the thickness from the example 1. Molded bodies for joining were obtained in a manner similar to the example 1 except therefor.

### <Examples 18 to 22 and comparative examples 9, 10>

In the examples 18 to 22 and the comparative examples 9, 10, as shown in the Table 2, the forming method was changed into the roll rolling forming to adjust a gap between rolls of the powder rolling mill so that molded bodies for joining thus obtained have thicknesses from the thickness of the example 1. Molded bodies for joining were obtained in a manner similar to the example 1 except therefor.

**Table 2**

| | Cu-core Sn-shell powder | | | Molded body precursor | | Forming condition | | | Joining evaluation | |
|---|---|---|---|---|---|---|---|---|---|---|
| | Average particle size (µm) | Composition | | Cu-Sn component (% by mass) | Activating agent component (% by mass) | Forming method (-) | Forming load (MPa) | Molded body thickness (µm) | Initial joining strength (MPa) | Thermal cycle (-) |
| | | Cu (% by mass) | Sn (% by mass) | | | | | | | |
| Example 14 | 5.0 | 75 | 25 | 99.0 | 1.0 | Uniaxial press | 500 | 20 | 39 | 0.83 |
| Example 15 | 5.0 | 75 | 25 | 99.0 | 1.0 | Uniaxial press | 500 | 50 | 43 | 0.90 |
| Example 16 | 5.0 | 75 | 25 | 99.0 | 1.0 | Uniaxial press | 500 | 200 | 53 | 0.90 |
| Example 17 | 5.0 | 75 | 25 | 99.0 | 1.0 | Uniaxial press | 500 | 400 | 45 | 0.89 |
| Comparative Example 7 | 5.0 | 75 | 25 | 99.0 | 1.0 | Uniaxial press | 500 | 15 | 18 | 0.45 |
| Comparative Example 8 | 5.0 | 75 | 25 | 99.0 | 1.0 | Uniaxial press | 500 | 450 | 38 | 0.29 |
| Example 18 | 5.0 | 75 | 25 | 99.0 | 1.0 | Roll rolling | - | 20 | 41 | 0.80 |
| Example 19 | 5.0 | 75 | 25 | 99.0 | 1.0 | Roll rolling | - | 50 | 49 | 0.90 |
| Example 20 | 5.0 | 75 | 25 | 99.0 | 1.0 | Roll rolling | - | 100 | 59 | 0.98 |
| Example 21 | 5.0 | 75 | 25 | 99.0 | 1.0 | Roll rolling | - | 200 | 53 | 0.89 |
| Example 22 | 5.0 | 75 | 25 | 99.0 | 1.0 | Roll rolling | - | 400 | 50 | 0.85 |
| Comparative Example 9 | 5.0 | 75 | 25 | 99.0 | 1.0 | Roll rolling | - | 15 | 23 | 0.49 |
| Comparative Example 10 | 5.0 | 75 | 25 | 99.0 | 1.0 | Roll rolling | - | 450 | 41 | 0.40 |

### <Comparative evaluation>

32 kinds of molded bodies for joining which were obtained in the examples 1 to 22 and the comparative examples 1 to 10 were respectively mounted on copper plates, and 2.5 mm square silicon chip elements of which back surface was subjected to Au sputtering were mounted thereon. The silicon chip element was maintained for 5 min at a maximum temperature of 300°C under nitrogen atmosphere by using the reflow furnace with a load of 1 MPa being applied to the silicon chip so that it is closely in contact with the copper plate to join the copper plates and the silicon chip element to obtain 32 kinds of joined samples. The initial joining strength test and the thermal cycle test were carried out by a method described below in connection with these joined samples to perform evaluation thereof. The evaluation results thereof are shown in Table 1 and Table 2.

### (1) Initial joining strength

Regarding the bonding strength, copper plates of 32 kinds of joined samples were respectively fixed to apply a force in a direction parallel to the copper plate from the silicon chip element side surface to measure a force when the silicon chip element is peeled or a force when it has broken (Newton in unit) by means of a die share tester (made by A&D company, Tensilon Universal Testing Device RTF-1310) to allow a value obtained by dividing this value by joining area 2.5 mm x 2.5 mm = 6.25mm² to be a joining strength (MPa in unit).

### (2) Thermal cycle

32 kinds of joined samples were respectively contained into a thermal cycle tester (made by Espec company, Thermal shock testing device TSA-73ES) to respectively set the lower limit temperature and the upper limit temperature to -40°C and 200°C to repeat temperature lowering and temperature elevation 1000 times to measure joining strength in accordance with a method similar to the initial joining strength of the above-mentioned item (1) to allow a value obtained through division by the initial joining strength to be a thermal cycle characteristic. This means that when this is 1.00, the initial strength is maintained, and means that when this is 0.50, there results lowering to one half of the initial joining strength.

When comparison between the examples 1 to 22 and the comparative examples 1 to 10 is made, the following facts were found out from the Tables 1 and 2.

Because there were used Cu-core Sn-shell powders which are too fine such that they have an average particle size of 0.3 µm in the comparative example 1, unevenness in thickness of molded bodies which have been subjected to press-forming is large, so the molded body cannot sufficiently contact at respective surfaces of the copper plate and the silicon chip element (hereinafter referred to as substrate and element) so that sufficient joining was not realized.

Because there were used Cu-core Sn-shell powders which are too coarse such that they have an average particle size of 60 µm in the comparative example 2, Sn of the liquid phase appears so that the initial joining between the substrate and the element was correspondingly obtained. However, because it takes much time that Cu diffuses into Sn, no inter-metallic compound is sufficiently produced through a thermal treatment of 5 min, so a reaction involving change in volume will be developed also during the thermal cycle test so that the joining strength could not be maintained.

Because the content of Cu in the Cu-core Sn-shell powder was too small such that it takes 50 % by mass, and the content of Sn was too large such that it takes 50% by mass in the comparative example 3, the Cu core will disappear, so it was impossible to sufficiently relax stress produced in the thermal cycle test so that it was impossible to sufficiently maintain the joining strength.

Because the content of Cu in the Cu-core Sn-shell powder is too large such that it takes 97% by mass, and the content of Sn is too small such that it takes 3% by mass in the comparative example 4, an amount of Sn liquid phase produced was insufficient, so it cannot wet-spread on the interface with the substrate or the element so that joining therebetween could not be performed. For this reason, it was impossible to carry out the initial joining strength test and the thermal cycle test.

Because the forming load at the time of the uniaxial press forming was too low such that it takes 5 MPa in the comparative example 5, it was impossible that there results in advance a densified molded body. For this reason, contact between molten Sn was difficult, so integrated bonding layer could not be obtained so that the initial joining strength was a lower value.

Because the forming load at the time of the uniaxial press forming was too high such that it takes 2000 MPa in the comparative example 6, the molded body becomes hard so that the molded body is not easily deformed, and even if pressure and temperature are applied to the molded body while being inserted between the substrate and the element, it was impossible to sufficiently ensure the contact surface without being capable of performing deformation following warp of the substrate or the element. From this fact, the molten Sn could not sufficiently wet-spread so that the initial joining strength did not reach a sufficiently high value.

Because the thickness of the molded body after the uniaxial press forming is too thin such that it takes 15µm in the comparative example 7, an amount of Sn liquid phase produced from the bonding layer was insufficient so that it could not sufficiently wet-spread on the substrate or the element. Thus, a value of the initial joining strength could not become equal to a sufficient value.

Because the thickness of the molded body after uniaxial press forming was too thick such that it takes 450 µm in the comparative example 8, the Sn liquid phase is sufficiently produced so that it was possible to obtain an initial joining strength, but because the thermal resistance is not small, heat is not easily dissipated from the molded body so that it was impossible to maintain the initial joining strength through the thermal cycle.

Because the thickness of the molded body after roll rolling forming was too thin such that it takes 15 µm in the comparative example 9, an amount of Sn liquid phase produced from the joining layer is insufficient, and cannot wet-spread on the substrate or the element so that the value of the initial joining strength was not sufficient.

Because the thickness of the molded body after roll rolling forming was too thick such that it takes 450 µm in the comparative example 10, the Sn liquid phase is sufficiently produced so that it was possible to obtain an initial joining strength, but because the thermal resistance was not small, heat was not easily dissipated so that it was impossible to maintain the initial joining strength through the thermal cycle test.

On the contrary, since the joined samples of the examples 1 to 22 were samples which were obtained by using molded bodies for joining, which have the requirement specified at the first point of view, and were manufactured in accordance with the requirement specified based on the second point of view, the initial bonding strength was high such that it takes 37 to 59 MPa, the thermal cycle was within the range of 0.68 to 0.98, and lowering of the joining strength by the thermal cycle test was not observed.

### Industrial Applicability

The present invention can be suitably utilized for mounting of electronic components which may be exposed to high temperature atmosphere.

## Claims

1. A molded body for joining composed of a compressed aggregate of Cu-core Sn-shell powders,
**characterized in**
**that** an activating agent-containing substance for eliminating an oxide on the surface of the powder exists on a surface portion of the molded body for joining and in open holes therewithin;
**that** the molded body for joining contains Cu in a ratio of 55 to 95% by mass and Sn in a ratio of 45 to 5% by mass respectively; and
**that** the molded body for joining has a thickness of 20 to 400 µm.

2. A method of manufacturing a molded body for joining, **characterized by** including:
a step of allowing Cu-core Sn-shell powders having an average particle size of 0.5 to 50 µm to undergo press forming or roll rolling forming at a pressure of 10 to 1000 MPa under the atmosphere of an inert gas to obtain a molded body precursor in the form of pellet or sheet having a thickness of 20 to 400 µm;
a step of storing, into a container, an activating agent-containing substance in the form of liquid for eliminating an oxide on the surfaces of the powders under the atmosphere of an inert gas to immerse the molded body precursor into the activating agent-containing substance;
a step of decompressing, together with the container, the immersed molded body precursor under the atmosphere of an inert gas to remove, from open holes within the molded body precursor, gas existing in the open holes;
a step of restoring a pressure of the molded body precursor in which the gas has been removed from the open holes so as to fill the activating agent-containing substance into the open holes; and
a step of eliminating an excess activating agent-containing substance attached on the surface of the molded body precursor in which the activating agent-containing substance has been filled in the open holes to obtain a molded body for joining, and
in that the Cu-core Sn-shell powder contains Cu in a ratio of 55 to 95% by mass and Sn in a ratio of 45 to 5% by mass.
